# EUROPÄISCHE PATENTSCHRIFT

(11) **EP 2 232 600 B1**
(45) Veröffentlichungstag und Bekanntmachung des Hinweises auf die Patenterteilung: **10.06.2015**
(21) Anmeldenummer: 09704138.8
(22) Anmeldetag: 22.01.2009
(51) Int. Cl.: H01L 41/083, H01L 41/047, H01L 41/273

(54) **PIEZOELEKTRISCHES VIELSCHICHTBAUELEMENT**
PIEZOELECTRIC MULTILAYER COMPONENT
COMPOSANT MULTICOUCHE PIÉZOÉLECTRIQUE

(30) Priorität: 23.01.2008 DE 102008005682
(43) Veröffentlichungstag der Anmeldung: 29.09.2010
(73) Patentinhaber: Epcos AG, 81669 München (DE)
(72) Erfinder: DERNOVSEK, Oliver, A-8010 Graz (AT); GLAZUNOV, Alexander, A-8530 Deutschlandsberg (AT)
(74) Vertreter: Epping - Hermann - Fischer
(86) Internationale Anmeldenummer: PCT/EP2009/000394
(87) Internationale Veröffentlichungsnummer: WO 2009/092584

(56) Entgegenhaltungen:
- WO-A-2006/135013
- WO-A-2007/097460

## Beschreibung

Es wird ein Verfahren zur Herstellung eines piezoelektrischen Vielschichtbauelements, sowie ein durch das Verfahren erzeugbares piezoelektrisches Vielschichtbauelement mit einem Bereich verringerter mechanischer Stabilität angegeben.

Aus DE 10 2006 031 085 A1 ist ein piezoelektrisches Vielschichtbauelement mit Sollbruchschichten bekannt . Die WO 2007/097460 A offenbart ein piezoelektrisches Vielschichtbauelement, das Elektrodenschichten und klumpenhaltige Schichten enthält.

Eine zu lösende Aufgabe besteht darin, ein piezoelektrisches Vielschichtbauelement anzugeben, welches über einen möglichst langen Zeitraum stabil betrieben werden kann.

Es wird ein piezoelektrisches Vielschichtbauelement als Zwischenprodukt mit einem Stapel von übereinander angeordneten, grünen piezokeramischen Schichten und abwechselnd übereinander angeordneten gegenpoligen Elektrodenschichten gemäß Anspruch 1 angegeben.

Eine erste Elektrodenschicht ist auf einer piezokeramischen Schicht aufgebracht und enthält ein erstes Metall. Eine Opferschicht ist auf einer weiteren piezokeramischen Schicht aufgebracht und benachbart die erste Elektrodenschicht in Stapelrichtung, wobei die Opferschicht das erste Metall in einer höheren Konzentration enthält, als die erste Elektrodenschicht. Der Begriff "Konzentration" bezeichnet dabei den Gewichtsanteil des Metalls in der jeweiligen Elektrodenschicht.

Wird das Zwischenprodukt gesintert, diffundiert das erste Metall aus der Opferschicht zur ersten Elektrodenschicht und hinterlässt dabei Hohlräume, wodurch eine Sollbruchschicht gebildet wird. Die Opferschicht ist somit eine metallische Schicht, die durch ihren Materialverlust während des Sinterns oder auch schon aufgrund ihrer Strukturierung im Betrieb keine Funktion als Elektrodenschicht aufnehmen kann und daher auch als "Opfer"-Schicht bezeichnet wird. Vorzugsweise ist das Verhältnis zwischen der Konzentration des ersten Metalls in der Opferschicht und des ersten Metalls in der ersten Elektrodenschicht derart gewählt, dass die Opferschicht ausreichend Material verliert, um insbesondere keinen elektrischen Kontakt zu gegebenenfalls vorhandenen Außenkontakten an den Außenflächen des Stapels aufweisen zu können.

Die erste Elektrodenschicht und die Opferschicht bilden ein gepaartes System, in dem ein Materialaustausch bei Erwärmung des piezoelektrischen Vielschichtbauelements stattfindet.

Vorzugsweise wird die Opferschicht als strukturierte Opferschicht ausgeführt. Dabei weist sie eine unterbrochene Struktur auf, d. h. sie deckt nur einen Teil der grünen piezokeramischen Schicht ab. Die Opferschicht ist beispielsweise als eine Anordnung von metallischen Inseln, die auf einer piezokeramischen Schicht aufgebracht sind, ausgeführt. Die strukturierte Opferschicht kann darüber hinaus Aussparungen aufweisen, insbesondere derart, dass sie als Netzstruktur nur einen Teil der grünen piezokeramischen Schicht abdeckt.

Das erste Metall in der ersten Elektrodenschicht kann gemäß einer Ausführungsform in einer Konzentration von weniger als 100 % vorliegen. Dabei wird bevorzugt, dass das erste Metall in der ersten Elektrodenschicht in einer Konzentration von bis zu 80 % vorliegt.

Es hat sich herausgestellt, dass als erstes Metall Kupfer besonders günstig ist, da es bei relativ niedrigen Temperaturen erweicht und somit ein schonendes Sintern des piezoelektrischen Vielschichtbauelements möglich ist, bei dem das Kupfer sich gut an eine piezokeramische Schicht bindet. Darüber hinaus hat sich herausgestellt, dass Kupfer, im Vergleich zu anderen Metallen, wie zum Beispiel Palladium oder Platin, verhältnismäßig leicht durch eine Piezokeramik diffundiert, wodurch die Herstellung eines nachfolgend beschriebenen piezoelektrischen Vielschichtbauelements mit einem Hohlräume aufweisenden, mechanischen geschwächten Bereich begünstigt wird.

Anstelle von Kupfer als erstes Metall kann ein anderes Metall verwendet werden, wie zum Beispiel Silber oder Nickel.

Gemäß einer Ausführungsform enthält die erste Elektrodenschicht ein zusätzliches, zweites Metall, das sich vom ersten Metall unterscheidet. Beim zweiten Metall handelt es sich vorzugsweise um Palladium.

Es wird bevorzugt, dass das zweite Metall schlechter durch eine der ersten Elektrodenschicht benachbarte piezokeramische Schicht diffundiert, als das erste Metall. Somit wird die Diffusion von Metall durch das Vielschichtbauelement überwiegend durch das erste Metall, insbesondere durch Kupfer erreicht, welches bei Erwärmung eine höhere Mobilität durch eine Piezokeramik aufweist.

Das zweite Metall ist vorzugsweise gewählt aus Palladium, Beryllium, Aluminium, Mangan, Zink, Zinn, Wismut, Nickel, Kobalt, Chrom, Molybdän, Niob, Rubidium, je nach dem, welches Metall als erstes Metall in der ersten Elektrodenschicht verwendet wird.

Es ist günstig, wenn in der ersten Elektrodenschicht das erste Metall in einer höheren Konzentration vorliegt, als das zweite Metall. Beispielsweise liegt das erste Metall in einer Konzentration von 70 % und das zweite Metall in einer Konzentration von 30 % in der ersten Elektrodenschicht vor. Damit eine Diffusion von der Opferschicht zur ersten Elektrodenschicht stattfinden kann, muss die Konzentration des ersten Metalls in der ersten Elektrodenschicht niedriger sein, als die Konzentration des ersten Metalls in der Opferschicht. Durch die Diffusion des ersten Metalls wird dessen Konzentrationsunterschied zwischen der ersten Elektrodenschicht und der Opferschicht verringert, d. h. die Konzentration des ersten Metalls in der Opferschicht nimmt ab.

Die Opferschicht kann neben den Metallen einen organischen Binder enthalten, der sich vorzugsweise noch vor dem Sintern des Zwischenprodukts durch eine geeignete Temperaturbehandlung verflüchtigt.

Erfindungsgemäß ist im Zwischenprodukt eine zweite Elektrodenschicht bereitgestellt, die auf einer weiteren piezokeramischen Schicht aufgebracht ist, wobei die zweite Elektrodenschicht das gleiche erste Metall enthält, wie die erste Elektrodenschicht beziehungsweise die Opferschicht. Dabei enthält

die zweite Elektrodenschicht das erste Metall in der gleichen oder nahezu gleichen Konzentration wie die Opferschicht. Damit soll wie Diffusion des ersten Metalls von der zweiten Elektrodenschicht in die Opferschicht möglichst verhindert werden, so dass die zweite Elektrodenschicht keinen oder nur einen äußerst geringen Materialverlust erleidet. Damit ist gewährleistet, dass nach dem Sintern des Zwischenprodukts die zweite Elektrodenschicht funktional als Elektrodenschicht dienen kann, d. h. dass sie zum Aufbau von elektrischen Feldern geeignet ist.

Es wird bevorzugt, dass die piezokeramischen Schichten des piezoelektrischen Vielschichtbauelements eine Keramik umfassend Blei-Zirkonat-Titanat (PZT) enthalten. Es hat sich herausgestellt, dass Metalle, insbesondere Kupfer, während des Sinterns des Zwischenprodukts mit verhältnismäßig geringem Widerstand durch eine PZT-Keramik diffundieren können. Somit kann der Diffusionsprozess eines Metalls zwischen zwei Bereichen des piezoelektrischen Vielschichtbauelements, in denen das erste Metall in unterschiedlichen Konzentrationen vorliegt, begünstigt werden.

Es wird außerdem ein Grünkörper als Zwischenprodukt bei der Herstellung eines piezoelektrischen Vielschichtbauelements angegeben, wobei übereinander gestapelte Grünfolien enthaltend eine piezoelektrische Keramik und dazwischen liegende Elektrodenschichten bereitgestellt sind, und wobei neben einer ersten Elektrodenschicht eine metallhaltige Opferschicht angeordnet ist, wobei die erste Elektrodenschicht ein erstes Metall als Hauptkomponente mit einem Gewichtsanteil größer als 50 % enthält. Die erste Elektrodenschicht enthält dabei ein vom ersten Metall verschiedenes zweites Metall als Nebenkomponente mit einem Gewichtsanteil kleiner als 50 %, wobei die Opferschicht das erste Metall als Hauptkomponente mit einem Gewichtsanteil enthält, der größer ist als der Gewichtsanteil in der ersten Elektrodenschicht.

Neben dem piezoelektrischen Vielschichtbauelement als Zwischenprodukt beziehungsweise als Grünkörper wird ein Verfahren zur Herstellung eines piezoelektrischen Vielschichtbauelements als Endprodukt beziehungsweise als gesintertes Produkt angegeben.

Dabei wird das als Zwischenprodukt hergestellte piezoelektrisches Vielschichtbauelement gesintert, wobei das erste Metall zumindest teilweise aus der Opferschicht zur ersten Elektrodenschicht diffundiert und dabei Hohlräume in dem ehemals mit der Opferschicht bedruckten Bereich hinterlässt, wodurch die Grenzfläche zwischen zwei piezokeramischen Schichten, zwischen denen die Opferschicht aufgebracht war, mechanisch geschwächt wird.

Auch wird ein piezoelektrisches Vielschichtbauelement angegeben, das unmittelbar nach dem hier beschriebenen Herstellungsverfahren, bei dem das Zwischenprodukt weiterverarbeitet wird, erzeugbar ist.

Die beschriebenen Gegenstände werden anhand der folgenden Ausführungsbeispiele und Figuren näher erläutert. Dabei zeigt:
- Figur 1: einen Längsschnitt eines piezoelektrischen Vielschichtbauelements,
- Figur 2: einen Abschnitt des Stapels eines piezoelektrischen Vielschichtbauelements,
- Figuren 3a und 3b: Polungsrisse in einem piezoelektrischen Vielschichtbauelement,
- Figur 4: einen Abschnitt des Stapels eines grünen piezoelektrischen Vielschichtbauelements mit einer strukturierten metallischen Opferschicht,
- Figuren 5a bis 5f: verschiedene Ausführungsformen einer Opferschicht,
- Figuren 6a bis 6d: einen Abschnitt des Stapels eines grünen piezoelektrischen Vielschichtbauelements mit bezüglich der Querschnittsfläche des Stapels verschiedenen Anordnungsmöglichkeiten einer strukturierten Opferschicht,
- Figuren 7a bis 7d: einen Abschnitt des Stapels eines grünen piezoelektrischen Vielschichtbauelements mit bezüglich der Stapelrichtung verschiedenen Anordnungsmöglichkeiten einer oder mehrerer Opferschichten,
- Figur 8: einen Abschnitt des Stapels eines grünen piezoelektrischen Vielschichtbauelements mit einer wiederholenden Anordnung von ersten Elektrodenschichten, Opferschichten und zweiten Elektrodenschichten,
- Figur 9: einen Abschnitt des Stapels eines grünen piezoelektrischen Vielschichtbauelements mit einer wiederholenden Anordnung von ersten Elektrodenschichten und Opferschichten,
- Figur 10: einen Abschnitt des Stapels eines gesinterten piezoelektrischen Vielschichtbauelements mit einem Hohlräume aufweisenden Grenzbereich zwischen zwei piezokeramischen Schichten.

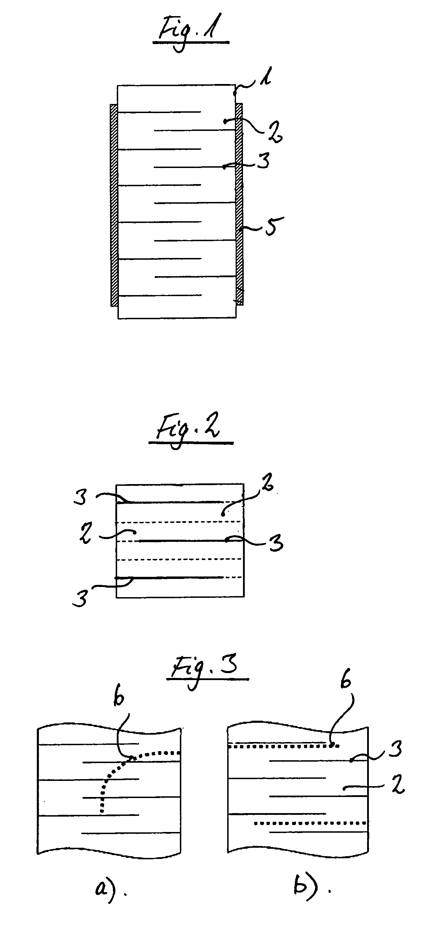

Figur 1 zeigt den Querschnitt eines schematisch dargestellten Piezoaktors, der einen Stapel 1 von piezokeramischen Schichten 2 und dazwischen liegenden Elektrodenschichten 3 aufweist. An zwei Längsseiten des Stapels 1 sind Außenkontakte als externe Metallisierungen 5 aufgebracht, die die bis an diese Längsseiten herangeführten Enden der Elektrodenschichten 3 kontaktieren. Benachbarte Elektrodenschichten unterschiedlicher Polarität überlappen sich in orthogonaler Projektion, welche parallel zur Stapelachse des Piezoaktors verläuft. Im Überlappbereich, der als aktive Zone bezeichnet wird, führt ein elektrisches Feld zur Erzeugung einer Auslenkung beziehungsweise Dehnung einer zwischen diesen Elektrodenschichten vorhandenen piezokeramischen Schicht 2. Der Bereich, in denen sich gegenpolige, benachbarte Elektrodenschichten 3 nicht überlappen, wird als inaktive Zone bezeichnet. In diesem Bereich kommt so gut wie keine Auslenkung durch den piezoelektrischen Effekt zustande. Das Material in den Elektrodenschichten 3 ist so gewählt, dass sie beim Sinterprozess nicht übermäßig aufschmelzen beziehungsweise dass die Struktur der aufgedruckten Elektrodenschicht bei und nach dem Sintern im Wesentlichen unverändert bleibt.

Figur 2 zeigt einen Abschnitt eines Stapels 1 eines Piezoaktors, bei dem zwischen gegenpoligen, benachbarten Elektrodenschichten 3 mehrere piezokeramische Schichten 2 übereinander gestapelt sein können. Auch ein solcher Abschnitt dient als Basis einer Konstruktion für nachfolgend beschriebene Ausführungsformen eines Piezoaktors, denn zwischen den zusätzlichen piezokeramischen Schichten 2 können weitere Elektrodenschichten 3 beziehungsweise Opferschichten aufgebracht werden, welche durch ihre verschiedenen Materialzusammensetzungen Diffusionsprozesse anregen können.

Figur 3a zeigt, wie ein Riss 6 mehrere Elektrodenschichten 3, insbesondere gegenpolige Elektrodenschichten 3 eines Piezoaktors, verbindet.

Die Erfinder haben festgestellt, dass die Zuverlässigkeit eines Piezoaktors entscheidend von der Beherrschung eventuell auftretender Risse abhängt. Bei thermischen Prozessen wie zum Beispiel beim Sintern bei Temperaturen zwischen 800 und 1500° C, Metallisieren und Löten sowie bei der Polarisation des gesinterten Piezoaktors entstehen aufgrund der unterschiedlichen Dehnung in der aktiven und inaktiven Zone mechanische Spannungen, die zu so genannten Entlastungsrissen und/oder Polungsrissen des Piezoaktors führen. Diese laufen in der inaktiven Zone entlang oder in einer Elektrodenschicht 3. Beim Übergang in den aktiven Bereich können diese Risse abknicken. Wenn diese Risse dabei mindestens zwei Elektrodenschichten überbrücken, können Kurzschlüsse entstehen, welche zum Versagen des Piezoaktors führen können. Risse, die parallel zu den Innenelektroden verlaufen, stellen dagegen nahezu keine Gefahr für die Lebensdauer von Piezoaktoren dar.

Figur 3b zeigt einen unschädlichen Verlauf eines Risses 6 im Stapel 1 eines Piezoaktors. Dabei verläuft der Riss im Wesentlichen parallel zu einer Elektrodenschicht 3 beziehungsweise zu einer piezokeramischen Schicht 2, so dass der Riss keine gegenpoligen Elektrodenschichten verbindet und damit auch keine Kurzschlüsse verursacht.

Eine Idee zur Vermeidung von schädlichen Rissen wie in Figur 3a liegt in der Verwendung von benachbarten metallischen Schichten aus verschiedenen Materialien, um Diffusionsprozesse, die aufgrund der unterschiedlichen Zusammensetzungen dieser metallischen Schichten während des Sintervorgangs bei höheren Temperaturen stattfinden sollen, anzuregen. Während des Diffusionsprozesses soll eine metallische Schicht, beziehungsweise eine Komponente einer Legierung dieser Schicht, mehr Material verlieren als die andere. Dabei werden in dieser metallischen Schicht Hohlräume entstehen, welches zur mechanischen Abschwächung dieser Schicht führen wird. Polungsrisse oder andere Risse werden daher bevorzugt in der mechanisch abgeschwächten metallischen Schicht entstehen und sich nur innerhalb der Schicht fortpflanzen.

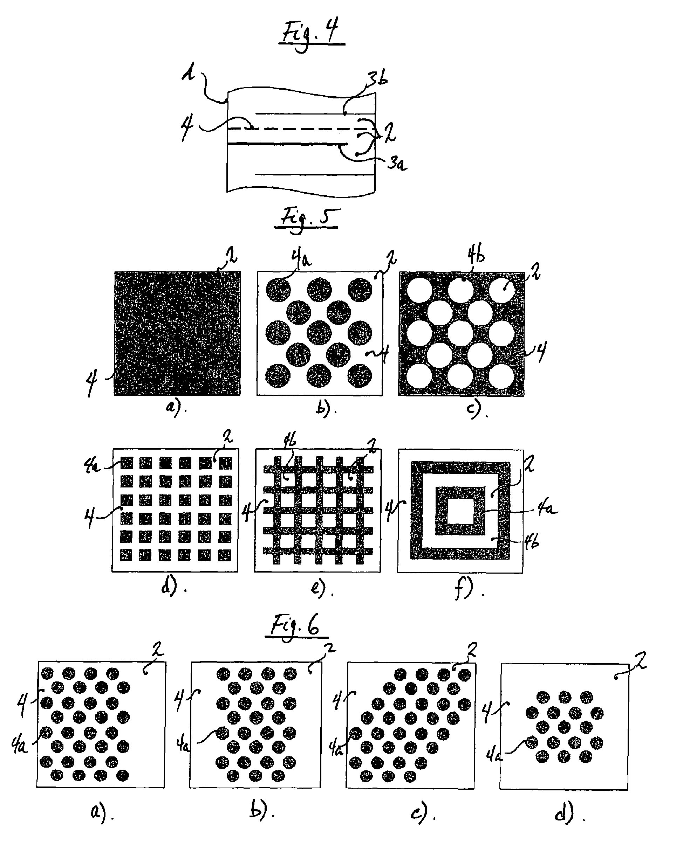

Figur 4 zeigt nun einen Längsschnitt eines schematisch dargestellten Abschnitts eines Stapels 1 eines Piezoaktors, wobei eine Opferschicht 4 auf einer piezokeramischen Schicht 2 angeordnet ist, wobei die Opferschicht zwischen einer ersten Elektrodenschicht 3a und einer zweiten Elektrodenschicht 3b angeordnet ist und diese Elektrodenschichten gegenpolig und in Stapelrichtung benachbart sind. Benachbart in Stapelrichtung heißt in diesem Zusammenhang, dass sich zwischen der ersten Elektrodenschicht 3a und der zweiten Elektrodenschicht 3b keine weiteren funktionalen Elektrodenschichten befinden.

In einer bestimmten Anzahl von ersten Elektrodenschichten 3a kann beispielsweise anstelle von ausschließlich Kupfer ein Material mit Zusammensetzung (1-x) Cu / x Pd verwendet werden, wobei 0 < x < 1 ist. Dieses Material kann entweder eine Mischung aus Kupfer- und Palladiumpulver sein oder eine Legierung aus diesen beiden Metallen. Die erste Elektrodenschicht 3a enthält somit eine Mischung aus Kupfer und Palladium, die Opferschicht 4 dagegen als Metall vorzugsweise nur Kupfer. Alternativ dazu kann anstelle von Kupfer auch ein anderes Metall, wie z. B. Silber, eingesetzt werden. Die erste Elektrodenschicht 3a enthält beispielsweise eine Mischung oder eine Legierung aus Silber und Palladium. Die Opferschicht 4 enthält vorzugsweise nur Silber.

Der Unterschied in der Zusammensetzung der ersten Elektrodenschicht 3a und der Opferschicht 4 wird bei höheren Temperaturen Diffusionsprozesse anregen. Es hat sich gezeigt, dass das Kupfer eine höhere Mobilität in piezoelektrischen Keramiken auf Basis von PZT zeigt als Palladium. Dies führt dazu, dass die Diffusion nur in eine Richtung stattfindet, nämlich aus der Opferschicht 4 aus reinem Kupfer in die erste Elektrodenschicht 3a enthaltend Kupfer und Palladium. Die Kupfer und Palladium enthaltende erste Elektrodenschicht 3a spielt somit die Rolle einer Kupfersenke. Der Materialverlust in der Opferschicht 4 in direkter Nachbarschaft zur ersten Kupfer-Palladium-Elektrodenschicht 3a führt zur Bildung von Hohlräumen, die das Interface zwischen der ehemals vorhandenen Opferschicht und umliegenden piezokeramischen Schichten 2 schwächt. Somit werden Bedingungen geschaffen für Bildung und Fortpflanzung von kontrollierten Rissen gemäß Figur 3b, die im Wesentlichen innerhalb des Interfaces und somit parallel zu piezokeramischen Schichten 2 verlaufen.

Der Anteil von Hohlräumen in der Opferschicht 4 kann durch die Zusammensetzung der ersten Elektrodenschichten 3a und der Opferschicht 4, die Dicke der Schichten sowie durch eine räumliche Strukturierung der Opferschicht 4 gesteuert werden.

Die Opferschicht 4 ist vorzugsweise als Muster von metallischen Inseln oder als Metallschicht mit einem Muster von Aussparungen auf einer piezokeramischen Schicht 2 aufgebracht. Vorzugsweise enthält der metallische Bereich beziehungsweise die metallischen Bereiche einer derartigen, strukturierten Opferschicht 4 lediglich das erste Metall, in diesem Beispiel Kupfer.

Vorzugsweise wird die strukturierte Opferschicht 4 mittels Siebdrucken, Sputtern oder Sprühen auf die piezokeramische Schicht aufgebracht.

Die piezokeramischen Schichten enthalten beispielsweise eine Keramik mit einer Zusammensetzung gemäß den folgenden Formeln:

(PbₓNd_{y}) ((Zr_{1-z}Ti_{z})₁₋ₐ Niₐ)O₃,

wobei
0,90 ≤ x ≤ 1,10;
0,0001 ≤ y ≤ 0,06;
0,35 ≤ z ≤ 0,60;
0 ≤ a ≤ 0,10.

Vorzugsweise sind 10 % der Gesamtzahl der Elektrodenschichten im Piezoaktor erste Elektrodenschichten 3a, d. h. sie enthalten ein erstes Metall in geringerer Konzentration als eine Opferschicht 4.

Es folgt eine genauere Beschreibung einer bevorzugten Zusammensetzung der ersten Elektrodenschicht 3a. Dabei ist

Kupfer zu einem Gewichtsanteil von 99,9 % bis 70 %, insbesondere zu einem Anteil von 97 % bis 75 %, in der ersten Elektrodenschicht 3a vorhanden. Der Rest der ersten Elektrodenschicht enthält als Metall Palladium, wobei hier gegebenenfalls verwendete organische Binder nicht mit einberechnet sind. Dabei wird entweder eine Legierung aus Kupfer und Palladium oder eine Mischung aus Kupferpulver und Palladiumpulver verwendet.

Kupferpartikel in der ersten Elektrodenschicht 3a und/oder in der Opferschicht 4 weisen Durchmesser von 0,1 bis 10 µm, vorzugsweise 0,4 bis 1,5 µm, auf.

Palladiumpartikel in der ersten Elektrodenschicht 3a weisen ebenfalls Durchmesser von 0,1 bis 10 µm, vorzugsweise 0,4 bis 1,5 µm auf. Andere Metallpartikel, beispielsweise Silberpartikel, können ebenfalls diese Größen aufweisen.

Die Partikelgrößen in einer Legierung in der ersten Elektrodenschicht 3a, das heißt bei einer Verbindung von verschiedenen Metallen, die nicht separat in der Form von verschiedenen Pulvern vorliegen, können ebenfalls die oben genannten Abmessungen aufweisen.

Vorzugsweise wird auch die erste Elektrodenschicht 3a mittels Siebdruck, Sputtern oder Sprühen auf eine piezokeramische Schicht 2 aufgebracht. Vorteilhafterweise kann dabei derselbe Bedruckungsprozess verwendet werden, der für die Erzeugung der Opferschicht 4 verwendet wird.

Die Dicke einer ersten Elektrodenschicht 3a im nicht gesinterten Zustand des Piezoaktors liegt vorzugsweise zwischen 0,1 und 20 µm, vorzugsweise 1,0 und 10 µm.

Der Anteil von ersten Elektrodenschichten 3a kann zwischen 1 % und 100 % der Gesamtzahl der Elektrodenschichten des piezoelektrischen Vielschichtbauelements betragen. In einer bevorzugten Ausführungsform liegt der Anteil der ersten Elektrodenschichten im Bereich zwischen 5 % und 15 %. Vorzugsweise befindet sich neben jeder ersten Elektrodenschicht 3a mindestens eine Opferschicht 4.

Figur 5a zeigt eine Draufsicht auf eine Opferschicht 4, die die gesamte Oberfläche einer piezokeramischen Schicht 2 abdeckt. Durch den Materialverlust dieser Opferschicht 4 während des Sinterns werden Hohlräume erzeugt. Bei geeigneter Wahl der Materialzusammensetzung der Opferschicht kann nahezu die gesamte Menge des ersten Metalls während des Sinterns zur ersten Elektrodenschicht diffundieren. Währenddessen können sich die benachbarten piezokeramischen Schichten 2 jedoch nicht fest aneinander binden, so dass die Grenzfläche zwischen diesen piezokeramischen Schichten 2 mechanisch geschwächt wird und somit während des Betriebs des Piezoaktors als Sollbruchschicht dienen kann.

Figur 5b zeigt eine Draufsicht auf eine strukturierte Opferschicht 4, die als Anordnung von metallischen Inseln 4a, die nur einen Teil der Oberfläche einer piezokeramischen Schicht 2 abdecken, ausgeführt ist. Die metallischen Inseln 4a sind hier kreisförmig, können jedoch jeweils einen beliebig anderen Umriss aufweisen, beispielsweise einen polygonalen Umriss. Die metallischen Inseln 4a sind vorzugsweise in einem regelmäßigen Muster auf der piezokeramischen Schicht 2 aufgebracht, so dass sie jeweils die gleichen Abstände zueinander aufweisen. Eine solche regelmäßige Struktur ist jedoch kein Erfordernis.

Figur 5c zeigt eine Draufsicht auf eine strukturierte, metallische Opferschicht 4 mit Aussparungen beziehungsweise Löchern 4b, so dass die Schicht 4 nur einen Teil der Oberfläche einer piezokeramischen Schicht 2 abdeckt. Die bedruckte Struktur ist ein Negativbild der Struktur der vorhergehenden Figur. Die Löcher 4b sind vorzugsweise kreisförmig und in regelmäßigen Abständen voneinander beabstandet. Der mit der metallischen Schicht 4 bedruckte Bereich der piezokeramischen Schicht kann bis zum Rand der piezokeramischen Schicht reichen. Da das aufgedruckte erste Metall jedoch später während des Sinterns des grünen Stapels abwandert, bleibt am Randbereich der piezokeramischen Schicht ein Hohlraum, so dass außen am Stapel aufgebrachte externe Metallisierungen keinen elektrischen Kontakt mehr in den inneren Bereich des Stapels 1 auf der Ebene des abgewanderten ersten Metalls aufweisen.

Figur 5d zeigt eine Ausführungsform der strukturierten metallischen Opferschicht 4, bei der die metallischen Inseln 4a quadratisch sind.

Figur 5e zeigt eine metallische Opferschicht 4, die als Netzstruktur auf einer piezokeramischen Schicht 2 aufgebracht ist. Somit ist das erste Metall in einer zusammenhängenden Struktur, welche quadratische Aussparungen 4b einschließt, auf die piezokeramische Schicht 2 aufgebracht. Im Unterschied zu der in Figur 5c gezeigten Struktur sind hier die Aussparungen 4b quadratisch anstatt kreisförmig und der metallische Bereich reicht nicht bis hin zum Rand des Stapels 1.

Figur 5f zeigt eine metallische Opferschicht 4, die als eine Anordnung von konzentrischen, rahmenförmigen metallischen Bereichen auf einer piezokeramischen Schicht 2 aufgebracht ist. Die metallischen Bereiche können dabei kreisförmige oder quadratische Umrisse aufweisen. Sie können als rahmenförmige, metallische Inseln, die ein gemeinsames Zentrum aufweisen, verstanden werden. Diese Ausführungsform kann als eine Kombination von metallischen Inseln 4a gemäß Figur 4b und Aussparungen 4b gemäß Figuren 4c und 4e verstanden werden.

Die Figuren 6a bis 6d stellen verschiedene Positionen einer Anordnung von metallischen Inseln 4a auf einer Oberfläche einer piezokeramischen Schicht 2 dar. Beispielsweise kann eine erste Anordnung von metallischen Inseln, die einen im Wesentlichen rechteckigen Umriss aufweist, mit einer Seite dieses rechteckigen Umrisses bis zu einer Längsseite des Stapels 1 reichen (Figur 6a) jedoch mit einer gegenüberliegenden Seite des Umrisses der Inselanordnung einen Abstand zur gegenüberliegenden Längsseite des Stapels aufweisen. Stattdessen können auch gegenüberliegende Seiten eines rechteckigen Umrisses einer Anordnung von metallischen Inseln bis hin zu zwei sich gegenüberliegenden Längsseiten des Stapels reichen und gegenüber den weiteren Längsseiten zurückversetzt sein (Figur 6b). Zusätzlich oder alternativ kann die Anordnung von metallischen Inseln einen Umriss in der Form eines Parallelogramms aufweisen, sodass zwei Ecken dieses Umrisses bis hin zu zwei Ecken des Stapels reichen (Figur 6c). Alternativ kann sich die Anordnung von metallischen Inseln lediglich im inneren Bereich der Oberfläche einer piezokeramischen Schicht befinden, sodass kein Teil des Umrisses der Anordnung bis zur eine Längsseite des Stapels reicht.

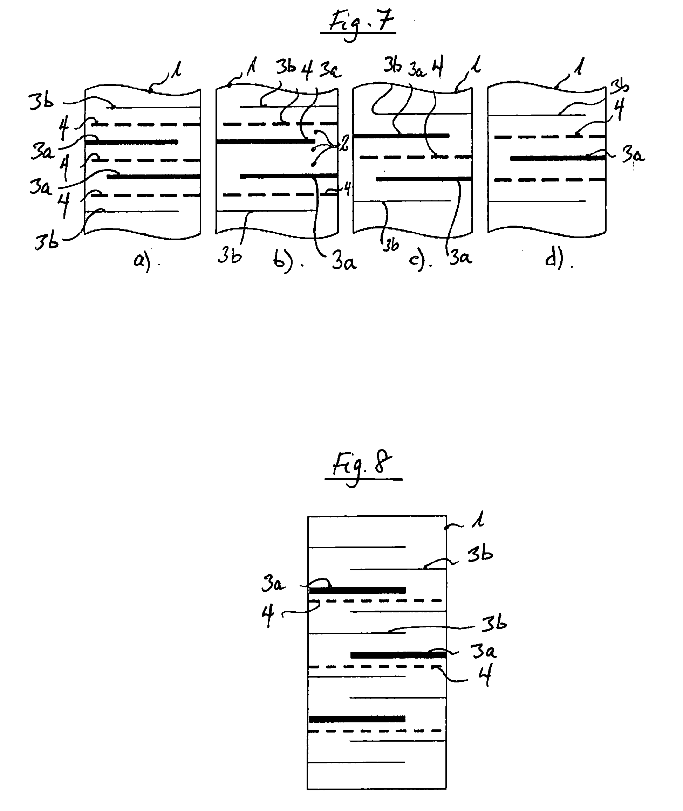

Die Figuren 7a bis 7d zeigen den Längsschnitt eines Abschnitts eines Stapels 1 eines Piezoaktors mit verschiedenen Anordnungsmöglichkeiten von ersten Elektrodenschichten 3a und Opferschichten 4, die in Stapelrichtung jeweils von zweiten Elektrodenschichten 3b umschlossen sind. Die hier gezeigten Kombinationen aus ersten Elektrodenschichten 3a und Opferschichten 4 können beliebig oft im Stapel vorhanden sein und müssen nicht alle von zweiten Elektrodenschichten 3b umschlossen sein. Figur 7a zeigt eine Anordnung , bei der eine erste Elektrodenschicht 3a, die ein erstes Metall in einer geringeren Konzentration enthält, als das erste Metall in einer Opferschicht 4, zwischen zwei in Stapelrichtung benachbarten Opferschichten 4 angeordnet ist, die jeweils eine Struktur gemäß einer der Figuren 5a bis 6d aufweisen können. Zwei erste Elektrodenschichten 3a sind dabei in Stapelrichtung benachbart. Jede erste Elektrodenschicht 3a ist in Stapelrichtung von zwei Opferschichten 4 umschlossen. Eine "innere" Opferschicht grenzt in Stapelrichtung an zwei erste Elektrodenschichten 3a an. Zwei "äußere" Opferschichten grenzen jeweils an eine erste Elektrodenschicht 3a und an eine zweite Elektrodenschicht 3b an, deren Metallanteil vorzugsweise gänzlich aus dem ersten Metall gebildet ist. Beispielsweise setzt sich die derartige Anordnung aus Opferschicht, erster Elektrodenschicht, Opferschicht, erster Elektrodenschicht und Opferschicht in Stapelrichtung fort. Die erste Elektrodenschicht 3a enthält dabei vorzugsweise eine Mischung eines ersten Metalls, beispielsweise Kupfer, und eines zweiten Metalls, beispielsweise Palladium. Das Kupfer zweier Opferschichten 4, zwischen denen eine erste Elektrodenschicht 3a angeordnet ist, kann zu dieser ersten Elektrodenschicht diffundieren und dabei Hohlräume hinterlassen. Die erste Elektrodenschicht 3a dient somit als Senke für das erste Metall aus zwei Opferschichten.

Figur 7b zeigt ein Ausführungsbeispiel, bei der eine Opferschicht 4 mit dem ersten Metall zwischen einer ersten 3a und einer zweiten Elektrodenschicht 3b positioniert ist. Bezogen auf die Stapelrichtung des Stapels 1 kann sich jedoch die erste Elektrodenschicht 3a beziehungsweise die zweite Elektrodenschicht 3b ober- oder unterhalb der Opferschicht 4 befinden. Anordnungen solcher Dreiergruppen können mittels mehrerer piezokeramischer Schichten 2 voneinander beabstandet sein. In dem hier gezeigten Ausführungsbeispiel liegen zwischen zwei funktionalen Elektrodenschichten immer zwei piezokeramische Schichten.

Gemäß Figur 7c ist eine Opferschicht 4 zwischen zwei in Stapelrichtung benachbarten, gegenpoligen ersten Elektrodenschichten 3a angeordnet. Hier "teilen" sich also zwei erste Elektrodenschichten 3a eine Opferschicht. So kann das erste Metall aus der Opferschicht 4 beim Sintern des Piezoaktors gleichzeitig in zwei benachbarte erste Elektrodenschichten 3a diffundieren. Auch hier enthalten die ersten Elektrodenschichten 3a vorzugsweise ein zweites, durch eine Piezokeramik schlecht diffundierbares Metall wie zum Beispiel Palladium.

Gemäß Figur 7d wechseln sich erste Elektrodenschichten 3a und zweite Elektrodenschichten 3b in Stapelrichtung regelmäßig ab, wobei die ersten Elektrodenschichten 3a jeweils von zwei Opferschichten 4 umgeben sind.

Figur 8 zeigt einen Abschnitt eines Stapels 1 eines grünen piezoelektrischen Vielschichtbauelements, bei der ein Paar aus erster Elektrodenschicht 3a und Opferschicht 4 in regelmäßigen Abständen im Stapel vorhanden sind. Die übrigen Elektrodenschichten sind zweite Elektrodenschichten 3b.

Eine Vielzahl von zweiten Elektrodenschichten 3b können durch Paare aus ersten Elektrodenschichten 3a und Opferschichten 4 ersetzt werden. Es kann jedoch in einem Stapel nur ein einziges derartiges Paar vorgesehen sein.

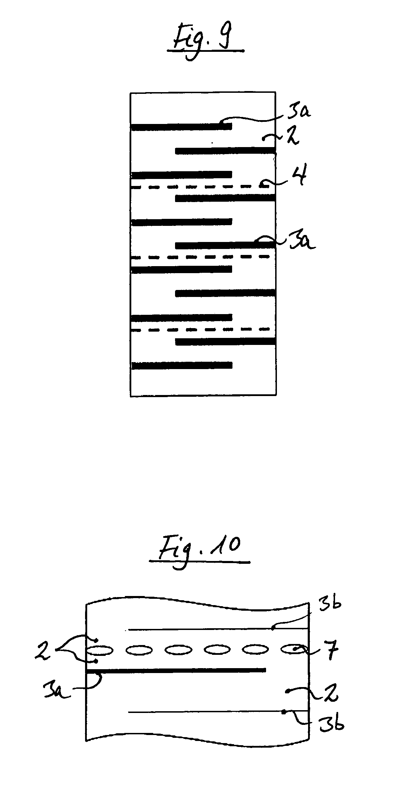

Figur 9 zeigt einen Abschnitt eines Stapels eines nicht-erfindungsgemäßen grünen piezoelektrischen Vielschichtbauelements, bei dem lediglich erste Elektrodenschichten 3a und Opferschichten 4 vorhanden sind und zweite Elektrodenschichten fehlen. Zwischen einigen gegenpoligen ersten Elektrodenschichten 3a, die beispielsweise hauptanteilig Kupfer und nebenanteilig Palladium enthalten, ist eine Opferschicht 4, dessen Metallanteil vorzugsweise ganz aus Kupfer besteht, angeordnet. Dabei ist in Stapelrichtung nicht jede erste Elektrodenschicht 3a zu einer Opferschicht 4 benachbart. Die Opferschichten 4 können in beliebiger Anzahl im Stapel vorhanden sein. Beispielsweise kann nur eine Opferschicht 4 vorgesehen sein oder es kann sich auch neben jeder ersten Elektrodenschicht 3a eine Opferschicht 4 befinden.

Figur 10 zeigt einen Abschnitt eines Stapels 1 eines gesinterten piezoelektrischen Vielschichtbauelements, bei dem an der Grenze zwischen zwei piezokeramischen Schichten 2 Hohlräume 7 gebildet sind, wobei vor dem Sintern an der Stelle der Hohlräume 7 das erste Metall der Opferschicht vorhanden war. Beim Sintern wanderte das erste Metall der Opferschicht per Diffusion zu einer ersten Elektrodenschicht 3a mit einer geringeren Konzentration des ersten Metalls. Durch eine Strukturierung der Opferschicht, z. B. gemäß den Figuren 5b bis 5f und 6a bis 6d können die Hohlräume 7 gezielt an bestimmten Positionen des Interfaces erzeugt werden.

Der Diffusionsprozess kann zum einen durch eine geeignete Einstellung des Konzentrationsunterschiedes zwischen der Opferschicht 4 und einer benachbarten ersten Elektrodenschicht 3a mit der geringeren Konzentration des ersten Metalls erreicht werden.

Zum anderen kann der Diffusionsprozess mittels einer geeigneten Temperatursteuerung beim Sintern beziehungsweise beim Erwärmen des grünen Stapels erreicht werden. Die Figur 10 zeigt vorhandene Hohlräume zwischen einer ersten Elektrodenschicht 3a und einer zweiten Elektrodenschicht 3b. Die Diffusion des Metalls der Opferschicht erfolgte fast ausschließlich in Richtung der ersten Elektrodenschicht 3a, da die zweite Elektrodenschicht 3b eine Konzentration des ersten Metalls enthält, die gleich oder nahezu gleich ist, wie die Konzentration des ersten Metalls in der Opferschicht. Zwischen der Opferschicht 4 und der zweiten Elektrodenschicht 3b war somit kein nennenswerter Konzentrationsgradient vorhanden, der einen Diffusionsprozess des ersten Metalls zwischen ihnen anregen würde.

### Bezugszeichenliste

- 1: Stapel aus piezokeramischen Schichten und Elektrodenschichten
- 2: piezokeramische Schicht
- 3: Elektrodenschicht
- 3a: erste Elektrodenschicht
- 3b: zweite Elektrodenschicht
- 4: Opferschicht
- 5: Außenkontakt
- 6: Riss
- 7: Hohlräume

## Patentansprüche

1. Piezoelektrisches Vielschichtbauelement als Zwischenprodukt, aufweisend:
- einen Stapel (1) von übereinander angeordneten, grünen piezokeramischen Schichten (2) und abwechselnd übereinander angeordneten gegenpoligen Elektrodenschichten (3a, 3b), wobei
- eine erste dieser Elektrodenschichten (3a) auf einer piezokeramischen Schicht (2) aufgebracht ist und ein erstes Metall enthält,
- eine Opferschicht (4), die keine Funktion als Elektrodenschicht aufnehmen kann, die auf einer weiteren piezokeramischen Schicht aufgebracht ist und der ersten Elektrodenschicht in Stapelrichtung benachbart ist, wobei
- die Opferschicht (4) das erste Metall in einer höheren Konzentration enthält als die erste Elektrodenschicht (3a), **gekennzeichnet durch**
- eine zweite Elektrodenschicht (3b), die auf einer piezokeramischen Schicht (2) aufgebracht ist, der Opferschicht (4) in Stapelrichtung benachbart ist und die das erste Metall in der gleichen oder nahezu gleichen Konzentration enthält wie die Opferschicht.

2. Piezoelektrisches Vielschichtbauelement nach Anspruch 1, bei dem die Opferschicht (4) strukturiert ist.

3. Piezoelektrisches Vielschichtbauelement nach Anspruch 2, bei dem die strukturierte Opferschicht (4) auf der piezokeramischen Schicht (2) als Anordnung von Inseln aufgebracht ist.

4. Piezoelektrisches Vielschichtbauelement nach einem der Ansprüche 2 oder 3,
bei dem die strukturierte Opferschicht (4) Aussparungen (4b) aufweist, die frei vom ersten Metall sind.

5. Piezoelektrisches Vielschichtbauelement nach einem der vorhergehenden Ansprüche,
bei dem das erste Metall in der ersten Elektrodenschicht (3a) in einer Konzentration von bis zu 80 % vorliegt.

6. Piezoelektrisches Vielschichtbauelement nach einem der vorhergehenden Ansprüche,
bei dem das erste Metall Kupfer umfasst.

7. Piezoelektrisches Vielschichtbauelement nach einem der vorhergehenden Ansprüche,
bei dem die erste Elektrodenschicht (3a) ein zusätzliches, zweites Metall enthält, das sich vom ersten Metall unterscheidet.

8. Piezoelektrisches Vielschichtbauelement nach Anspruch 7,
bei dem das zweite Metall schlechter durch eine der ersten Elektrodenschicht (3a) benachbarte piezokeramische Schicht (2) diffundieren kann, als das erste Metall.

9. Piezoelektrisches Vielschichtbauelement nach einem der Ansprüche 7 oder 8,
bei dem das zweite Metall ausgewählt ist aus: Palladium, Beryllium, Aluminium, Mangan, Zink, Zinn, Wismut, Nickel, Kobalt, Chrom, Molybdän, Niob, Rubidium.

10. Piezoelektrisches Vielschichtbauelement nach einem der Ansprüche 7 bis 9,
bei dem in der ersten Elektrodenschicht (3a) das erste Metall in einer höheren Konzentration vorliegt, als das zweite Metall.

11. Verfahren zur Herstellung eines piezoelektrischen Vielschichtbauelements, bei dem ein als Zwischenprodukt hergestelltes piezoelektrisches Vielschichtbauelement nach einem der vorhergehenden Ansprüche gesintert wird, wobei das erste Metall zumindest teilweise aus der Opferschicht (4) in die erste Elektrodenschicht (3a) diffundiert und dabei Hohlräume (7) hinterlässt, wodurch die Grenzfläche zwischen zwei piezokeramischen Schichten, zwischen denen die Opferschicht (4) aufgebracht war, mechanisch geschwächt wird.

12. Verfahren nach Anspruch 11,
bei dem sich benachbarte piezokeramische Schichten (2) beim Sintern zwischen den Hohlräumen (7) verbinden.

13. Piezoelektrisches Vielschichtbauelement, das unmittelbar nach einem Verfahren der vorhergehenden Ansprüche erzeugbar ist.

## Claims

1. Piezoelectric multilayer component as an intermediate product, having:
- a stack (1) of green piezoceramic layers (2) which are arranged one on top of the other and of electrode layers (3a, 3b) of opposite polarity which are arranged alternately one on top of the other, wherein
- a first of said electrode layers (3a) is applied to a piezoceramic layer (2) and contains a first metal,
- a sacrificial layer (4) which cannot function as an electrode layer and which is applied to a further piezoceramic layer and is adjacent to the first electrode layer in the stacking direction, wherein
- the sacrificial layer (4) contains a higher concentration of the first metal than does the first electrode layer (3a),
**characterized by**
- a second electrode layer (3b), which is applied to a piezoceramic layer (2), is adjacent to the sacrificial layer (4) in the stacking direction and which contains the same or virtually the same concentration of the first metal as does the sacrificial layer.

2. Piezoelectric multilayer component according to Claim 1, in which the sacrificial layer (4) is structured.

3. Piezoelectric multilayer component according to Claim 2, in which the structured sacrificial layer (4) is applied as an arrangement of islands to the piezoceramic layer (2).

4. Piezoelectric multilayer component according to one of Claims 2 or 3,
in which the structured sacrificial layer (4) has cutouts (4b) which are free of the first metal.

5. Piezoelectric multilayer component according to one of the preceding claims,
in which the first metal is in a concentration of up to 80% in the first electrode layer (3a).

6. Piezoelectric multilayer component according to one of the preceding claims,
in which the first metal comprises copper.

7. Piezoelectric multilayer component according to one of the preceding claims,
in which the first electrode layer (3a) contains an additional, second metal, which is not the same as the first metal.

8. Piezoelectric multilayer component according to Claim 7,
in which the second metal cannot diffuse as well as the first metal through a piezoceramic layer (2) which is adjacent to the first electrode layer (3a).

9. Piezoelectric multilayer component according to one of Claims 7 or 8,
in which the second metal is selected from: palladium, beryllium, aluminum, manganese, zinc, tin, bismuth, nickel, cobalt, chromium, molybdenum, niobium, rubidium.

10. Piezoelectric multilayer component according to one of Claims 7 to 9,
in which the first metal is present in a higher concentration in the first electrode layer (3a) than is the second metal.

11. Method for producing a piezoelectric multilayer component in which a piezoelectric multilayer component according to one of the preceding claims, produced as an intermediate product, is sintered, wherein the first metal diffuses at least partially from the sacrificial layer (4) into the first electrode layer (3a) and in the process leaves cavities (7), thus mechanically weakening the interface between two piezoceramic layers between which the sacrificial layer (4) was applied.

12. Method according to Claim 11,
in which adjacent piezoceramic layers (2) are connected between the cavities (7) during sintering.

13. Piezoelectric multilayer component which can be produced directly using a method according to the preceding claims.

## Revendications

1. Composant multicouche piézoélectrique prenant la forme d'un produit intermédiaire, comportant :
- une pile (1) de couches piézoélectriques vertes (2) disposées les unes au-dessus des autres et de couches d'électrode (3a, 3b) de pôle contraire disposées en alternance les unes au-dessus des autres ;
- une première de ces couches d'électrode (3a) étant appliquée sur une couche piézoélectrique (2) et contenant un premier métal ;
- une couche sacrificielle (4) ne pouvant prendre aucune fonction de couche d'électrode, appliquée sur une autre couche piézoélectrique et connexe à la première couche d'électrode dans la direction de la pile ;
- la couche sacrificielle (4) contenant le premier métal en concentration supérieure à la première couche d'électrode (3a) ;
**caractérisé par** :
- une deuxième couche d'électrode (3b) appliquée sur une couche piézoélectrique (2) et connexe à la couche sacrificielle (4) dans la direction de la pile et contenant le premier métal en concentration identique ou quasi identique à la couche sacrificielle.

2. Composant multicouche piézoélectrique selon la revendication 1, dans lequel la couche sacrificielle (4) est structurée.

3. Composant multicouche piézoélectrique selon la revendication 2, dans lequel la couche sacrificielle (4) structurée est appliquée sur la couche piézoélectrique (2) sous la forme d'un agencement d'ilots.

4. Composant multicouche piézoélectrique selon l'une quelconque des revendications 2 ou 3, dans lequel la couche sacrificielle (4) structurée comprend des évidements (4b) exempts du premier métal.

5. Composant multicouche piézoélectrique selon l'une quelconque des revendications précédentes, dans lequel le premier métal est présent dans la première couche d'électrode (3a) dans une concentration pouvant atteindre 80 %.

6. Composant multicouche piézoélectrique selon l'une quelconque des revendications précédentes, dans lequel le premier métal comprend du cuivre.

7. Composant multicouche piézoélectrique selon l'une quelconque des revendications précédentes, dans lequel la première couche d'électrode (3a) contient un deuxième métal supplémentaire se différenciant du premier métal.

8. Composant multicouche piézoélectrique selon la revendication 7, dans lequel le deuxième métal peut diffuser moins bien que le premier métal à travers une couche piézoélectrique (2) connexe à la première couche d'électrode (3a).

9. Composant multicouche piézoélectrique selon l'une quelconque des revendications 7 ou 8, dans lequel le deuxième métal est sélectionné parmi : le palladium, le béryllium, l'aluminium, le manganèse, le zinc, l'étain, le bismuth, le nickel, le cobalt, le chrome, le molybdène, le niobium, le rubidium.

10. Composant multicouche piézoélectrique selon l'une quelconque des revendications 7 à 9, dans lequel dans la première couche d'électrode (3a), le premier métal est présent en concentration supérieure au deuxième métal.

11. Procédé de fabrication d'un composant multicouche piézoélectrique, dans lequel un composant multicouche piézoélectrique fabriqué sous la forme d'un produit intermédiaire selon l'une quelconque des revendications précédentes est fritté, le premier métal se diffusant au moins en partie hors de la couche sacrificielle (4) dans la première couche d'électrode (3a) et laissant en l'occurrence derrière lui des espaces creux (7), la surface limite entre deux couches piézoélectriques entre lesquelles la couche sacrificielle (4) est appliquée étant affaiblie de façon mécanique.

12. Procédé selon la revendication 11, dans lequel des couches piézoélectriques (2) connexes sont reliées pas frittage entre les espaces creux (7).

13. Composant multicouche piézoélectrique, pouvant être directement fabriqué à l'aide d'un procédé des revendications précédentes.
